# EUROPEAN PATENT SPECIFICATION

(11) **EP 1 480 301 B1**
(45) Date of publication and mention of the grant of the patent: **26.04.2006**
(21) Application number: 03253222.8
(22) Date of filing: 23.05.2003
(51) Int. Cl.: H01S 5/022, H05K 5/00, H05K 5/06

(54) **A hermetic casing, for optical and optoelectronic sub-assemblies**
Hermetisches Gehäuse für ein optisches oder optoelektronisches Modul
Boîtier hermétique, pour des dispositifs optiques ou optoelectroniques

(43) Date of publication of application: 24.11.2004
(73) Proprietor: Agilent Technologies, Palo Alto, CA 94303-0870 (US)
(72) Inventor: Franco, Delpiano c/o Agilent Technologies Italia, 10148 Torino (IT); Bruschi, Carlo c/o Agilent Technologies Italia, 10148 Torino (IT)
(74) Representative: Liesegang, Eva

(56) References cited:
- EP-A- 0 655 813
- GB-A- 2 095 604
- US-A- 5 483 095
- US-A- 5 500 768
- US-A1- 2002 018 500
- PATENT ABSTRACTS OF JAPAN vol. 018, no. 326 (E-1565), 21 June 1994 (1994-06-21) & JP 06 077602 A (MATSUSHITA ELECTRIC IND CO LTD), 18 March 1994 (1994-03-18)
- PATENT ABSTRACTS OF JAPAN vol. 007, no. 218 (E-200), 28 September 1983 (1983-09-28) & JP 58 111389 A (HITACHI SEISAKUSHO KK;OTHERS: 01), 2 July 1983 (1983-07-02)
- PATENT ABSTRACTS OF JAPAN vol. 009, no. 274 (E-354), 31 October 1985 (1985-10-31) & JP 60 117789 A (NIPPON DENKI KK), 25 June 1985 (1985-06-25)
- PATENT ABSTRACTS OF JAPAN vol. 009, no. 035 (E-296), 14 February 1985 (1985-02-14) & JP 59 177986 A (MATSUSHITA DENKI SANGYO KK), 8 October 1984 (1984-10-08)
- PATENT ABSTRACTS OF JAPAN vol. 009, no. 075 (E-306), 4 April 1985 (1985-04-04) & JP 59 208886 A (HITACHI SEISAKUSHO KK;OTHERS: 01), 27 November 1984 (1984-11-27)
- PATENT ABSTRACTS OF JAPAN vol. 009, no. 165 (E-327), 10 July 1985 (1985-07-10) & JP 60 039880 A (HITACHI SEISAKUSHO KK;OTHERS: 01), 1 March 1985 (1985-03-01)

## Description

The invention relates to providing local hermetic sealing to components such as optical and optoelectronic devices mounted in more complex optical and electronic hybrid integrated arrangements.

The invention was developed by paying specific attention to the need of providing hermetic (e.g. liquid and gas proof) mounting arrangements with electrical and optical signal feed-through for electro-optical sub-units included in hybrid integrated optical and electronic devices. A hermetically sealed container for a light-emitting semiconductor diode is disclosed e.g. in EP-A-0 655 813. Providing a seal between two components is taught e.g. by GB-A- 2 095 604.

The primary object of the invention is to limit the volume/extension to be hermetically sealed e.g. for the purpose of reducing cost and/or to avoid cross-contamination of components and materials enclosed in the same package due e.g. to organic compounds and vapour-releasing materials.

According to the present invention, that object is achieved by means of a mounting arrangement having the features set forth in the claims that follow.

The invention permits local hermetic sealing of optical or optoelectronic chips such as laser sources, photodetectors, LEDs mounted on a platform such as a glass or micromachined silicon platform, adapted to implement hybrid integrated circuits for electrical and optical signals.

The invention is defined in claim 1.

A particularly preferred embodiment of the invention is a mounting arrangement including:
- a substantially planar substrate having a portion defining a mounting location for a component such as an electro-optical device,
- a component such as an electro-optical device (and the ancillary elements possibly associated therewith) mounted on said substrate at said mounting location,
- a planar lightwave circuit (PLC) waveguide structure formed on said substrate, typically by conventional deposition and lithographic processes, and extending to said mounting location to define an hermetic optical signal feed-through for said component,
- at least one electrode structure formed on said substrate, again typically by conventional deposition and lithographic processes, associated with said planar lightwave circuit waveguide structure and extending to said mounting location to define an hermetic electrical signal feed-through for said component,
- a ring-like structure deposed on said optical and electrical feed-through structures, continuously surrounding said mounting location, said ring-like structure being hermetic to said planar substrate,
- a continuous cover member arranged to cover said mounting location and having a peripheral rim portion co-extensive with said ring-like structure, and
- a hermetic sealing mass extending continuously between said rim portion of said cover member and said ring-like structure, whereby said component is hermetically sealed at said mounting location.

The invention will now be described, by way of example only, with reference to the enclosed figures of drawing, wherein:
- figure 1 is a cross sectional view of a mounting arrangement according to the invention, and
- figure 2 is a sectional view essentially in the plane designated II-II in figure 1.

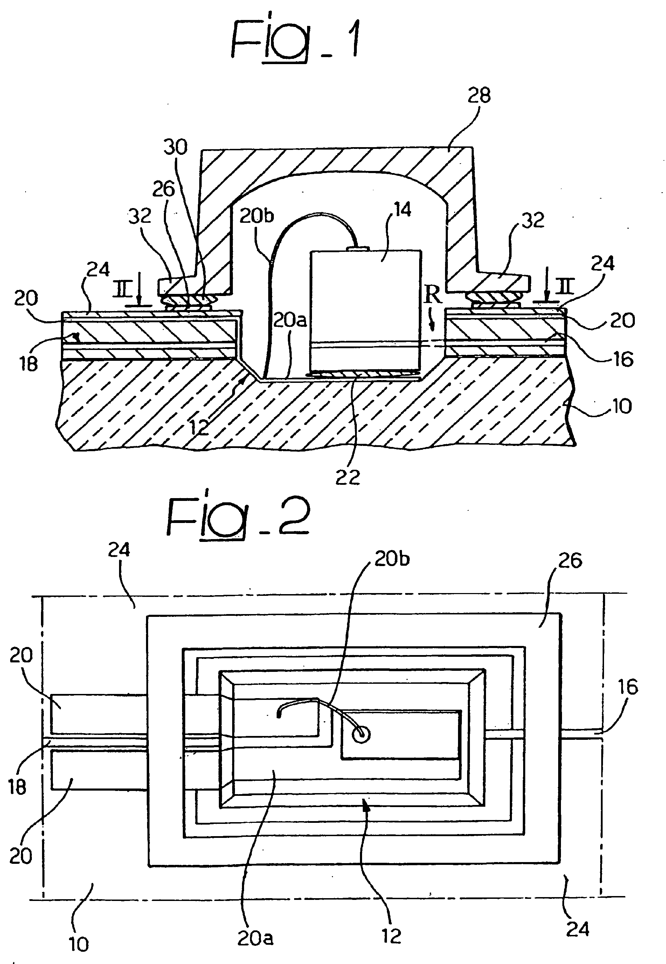

In figure 1, reference 10 designates a generally planar silica or silicon substrate having a portion defining a mounting region 12 for a device ("component") 14 comprised e.g. of an optical or optoelectronic chip such as a laser diode, a photodetector, a LED and so on.

The mounting region 12 for the component may be coplanar to the upper surface of the substrate 10 or possibly comprise a "sculptured" portion, namely a portion recessed in the substrate 10 or a heightened (i.e. raised) portion of the substrate 10. Such sculpturing can be obtained by standard means e.g. by micromachining.

The substrate 10 is adapted for creating thereon, according to standard planar lightwave circuit (PLC) manufacturing processes, an optical waveguide structure extending inside the mounting location (i.e. an optical feed-through) at both sides (if required) of the mounting region 12.

Specifically, in the arrangement shown herein, the waveguide structure in question includes a PLC waveguide 16 adapted for optical coupling with the device/component 14. For instance, if the component 14 is a laser diode, the PLC waveguide 16 may be coupled in such a way that radiation R emitted from the laser source 14 is injected into and propagated along the waveguide 16.

In case, another PLC waveguide 18 extends in substantial alignment with the waveguide 16 from the other side of the mounting region 12, for example to collect the rear emission of the laser source 14 for external monitoring purposes.

A pattern of electrodes 20 can be deposited over the PLC waveguide structure. One or more of those electrodes extend (as shown at 20a) into the mounting region 12 (through any side) to form electrical contacts (i.e. an electrical feed-through) to the component 14 and any associated ancillary electrical or electro-optical devices included in the mounting region.

Specifically, the component 14 can be mounted and connected via its bottom surface to the electrode extension 20a by means of a soldering mass 22 or an equivalent electrical connection means.

Other electrical connections required to ensure operation of the component(s) in the region 12 may be produced by standard techniques (such as wire bonding, as shown at 20b) e.g. to connect the top termination of the component 14 to the second termination of the electrode 20 extending into the region 12.

A dielectric insulating layer 24 is formed over the PLC waveguide structure and the electrode 20 structure to produce a substantially planar and insulating layer surrounding the mounting location 12. A typical choice for the material comprising the dielectric insulating layer 24 is e.g. silica or silicon nitride, preferably deposited by chemical vapour deposition (CVD) techniques.

A ring-like formation 26, comprised e.g. of a conventional vacuum deposited Ti-Pt-Au metal stack, may thus be provided extending continuously around the mounting location 12 for the component 14.

In the exemplary embodiment shown herein, the ring-like formation 26 has a substantially rectangular shape. Those of skill in the art will promptly appreciate that such a shape however is in no way mandatory. In fact, the formation 26 is essentially provided as a basis member surrounding continuously and hermetically (i.e. without any breaks or holes) over the layer 24 and around the region 12. This in view of rendering the mounting region 12 hermetic by applying thereon a lid or cap 28, forming a cover member adapted to be continuously and hermetically connected (e.g. by means of a soldering mass 30) to the ring formation 26, thus producing a hermetic structure encapsulating the component 14.

In brief, the ring formation 26 continuously surrounds the mounting location 12 of the component 14 and is hermetic to the planar substrate 10 (through the hermetic layers 24,20,16,18). In fact, no apertures, discontinuities, liquid or gas permeable features exist in the ring formation 26 that may permit liquids and/or gases to leak therethrough in an appreciable amount.

Preferably, the cover member 28 has a general cup-like configuration with a flat flange 32 extending from and around its mouth portion.

As best appreciated in figure 1, this latter portion faces downwardly when the cover member 28 is applied over and around the mounting region 12. Once the cover member 28 is applied to cover the component 14 with the flange 32 sealingly connected (e.g. soldered at 30) to the ring formation 26, the component 14 mounted on the substrate 10 is sealingly (i.e. hermetically) isolated from the outer environment and from possible cross-contamination by components/materials enclosed in the same package, e.g. due to organic compounds or vapour-releasing materials.

The component 14 (in particular its optical surfaces, that may be very sensitive) is protected with respect to the outer environment by the cap or lid 28. This is preferably comprised of a metal or ceramic cap soldered to the metal ring 26. This result is achieved by limiting the volume/extension that is hermetically sealed with considerable advantages in term of costs.

This arrangement can be easily implemented by using standard lithographic processes to define the sealing metal annular structure 26 while metal caps 28 with flat flanges 32 can be easily manufactured at low cost.

The arrangement shown also avoids the use of enclosures including optical windows implying optical waveguide discontinuity. In fact, the component 14 is optically coupled to the outside via the PLC waveguide 16 that comprises a completely hermetic optical signal feed-through.

The electrodes 20 ensure electrical signal feed-through. These are adapted to be manufactured with a high degree of accuracy by resorting to standard metallisation processes, while in no way adversely affecting the hermetic nature of the sealing arrangement provided around the component 14.

Those of skill in the art will promptly appreciate that providing a recessed area such as area 12 in the substrate 10 or a similarly heightened area (by standard micromachining) is a preferred, yet not mandatory feature of the arrangement shown to adapt the optical height between the component 40 and the optical waveguides 16,18 for the purpose of optimising the coupling therebetween.

Similarly, at least in the case of very "shallow" components, e.g. components having a reduced height with respect to the general plane of the substrate 10, the cap or lid 28 may be provided in the form of a flat or approximately flat cover lid adapted to be soldered or otherwise connected to the ring structure 26 along its outer periphery.

Of course, without prejudice to the underlying principles of the invention, the embodiments and details may vary, also significantly, with respect to what has been previously described and shown, by way of example only, without departing from the scope of the invention, as defined by the claims that follow. Specifically, it will be appreciated that any feature previously disclosed in connection with a given embodiment can be freely adapted to any other embodiment of the invention. Also, terms such as "optical", "light", "photosensitive", and the like are used herein with the meaning currently allotted to those terms in fiber and integrated optics, being thus intended to apply to radiation including, in addition to visible light, e.g. also infrared and ultraviolet radiation.

## Claims

1. A mounting arrangement including:
- a substantially planar substrate (10) having a portion (12) defining a mounting location for at least one optoelectronic component (14),
- an optoelectronic component (14) mounted on said substrate at said mounting location (12),
- at least one planar lightwave circuit (PLC) waveguide structure (16, 18) formed on said substrate (10) and extending to said mounting location (12) to define an optical signal feed-through for said component (14),
- at least one electrode (20) deposited over said planar lightwave circuit waveguide structure (16,18), said at least one electrode (20) extending to said mounting location (12) to define an electrical signal feed-through for said component (14),
- a ring-like structure (26) continuously surrounding said mounting location (12), said ring-like structure (26) being hermetic to said planar substrate (12), and
- a continuous cover member (28) arranged to cover said mounting location (12) and having a peripheral rim portion (32) co-extensive with said ring-like structure (26), and
- a hermetic sealing mass (30) extending continuously between said rim portion (32) of said cover member (28) and said ring-like structure (26), whereby said component (14) is hermetically sealed at said mounting location (12).

2. The arrangement of claim 1, **characterized in that** said substrate (10) is comprised of one of a glass, silicon or ceramic platform.

3. The arrangement of either of claims 1 or 2, **characterized in that** said planar substrate (10) has a sculptured portion (12) defining said mounting location (12) for said component (14).

4. The arrangement of any of the previous claims **characterised in that** it includes a dielectric layer (24) at least marginally covering said substrate (10) and **in that** said ring-like structure (26) is provided over said dielectric layer.

5. The arrangement of any of the previous claims, **characterized in that** said ring-like structure (26) is comprised of a metal material.

6. The arrangement of any of the previous claims, **characterized in that** said cover member (28) is a cup-like member.

7. The arrangement of either of claims 1 or 6, **characterized in that** said cover member (28) has a peripheral flat flange (32) defining said peripheral rim.

8. The arrangement of any of the previous claims, **characterized in that** hermetic sealing mass (30) is a soldering mass between said peripheral rim (32) of said cover member (28) and said ring-like formation (26).

9. The arrangement of any of the previous claims, **characterized in that** said component (14) has an associated mass of solder (22) providing electrical connection to said at least one electrode (20).

10. The arrangement of either of claims 1 or 9, **characterized in that** said at least one component (14) has at least one associated wire bonding element (20b) providing electrical connection to said at least one electrode (20).

11. The arrangement of any of the previous claims, **characterized in that** said cover member (28) is of a metal material.

## Revendications

1. Structure de montage comprenant :
un substrat sensiblement plan (10) ayant une partie (12) définissant un emplacement de montage pour au moins un composant optoélectronique (14) ;
un composant optoélectronique (14) monté sur le substrat à l'emplacement de montage (12) ;
au moins une structure de guide d'onde (16, 18) de circuit optique plan (PLC) formée sur le substrat (10) et s'étendant vers l'emplacement de montage (12) pour définir un signal optique fourni au composant (14) ;
au moins une électrode (20) déposée sur la structure de guide d'onde (16, 18) de circuit optique plan, ladite au moins une électrode (20) s'étendant vers l'emplacement de montage (12) pour définir un signal électrique fourni au composant (14) ;
une structure en anneau (26) entourant de façon continue l'emplacement de montage (12), la structure en anneau (26) étant hermétique à l'emplacement de montage (12) ;
un élément de couvercle continu (28) agencé pour couvrir l'emplacement de montage (12) et comportant une partie de rebord périphérique (32) s'étendant dans le même sens que la structure en anneau (26) ; et
une masse de scellement hermétique (30) s'étendant en continu entre la partie de rebord (32) de l'élément de couvercle (28) et la structure en anneau (26), d'où il résulte que le composant (14) est hermétiquement scellé au niveau de l'emplacement de montage (12).

2. Structure selon la revendication 1, **caractérisée en ce que** le substrat (10) est constitué d'un support en verre silicium ou céramique.

3. Structure selon la revendication 1 ou 2, **caractérisée en ce que** le substrat plan (10) présente une partie en relief (12) définissant l'emplacement de montage (12) pour le composant (14).

4. Structure selon l'une quelconque des revendications précédentes, **caractérisée en ce qu'**elle comprend une couche diélectrique (24) recouvrant au moins partiellement le substrat (10) et **en ce que** la structure en anneau (26) est prévue sur la couche diélectrique.

5. Structure selon l'une quelconque des revendications précédentes, **caractérisée en ce que** la structure en anneau (26) est en métal.

6. Structure selon l'une quelconque des revendications précédentes, **caractérisée en ce que** l'élément de couvercle (28) est un élément en forme de coupe.

7. Structure selon la revendication 1 ou 6, **caractérisée en ce que** l'élément de couvercle (28) comporte un premier flasque périphérique plat (32) définissant le rebord périphérique.

8. Structure selon l'une quelconque des revendications précédentes, **caractérisée en ce que** la masse de scellement hermétique (30) est une masse de soudure entre le rebord périphérique (32) de l'élément de couvercle (28) et la structure en anneau (26).

9. Structure selon l'une quelconque des revendications précédentes, **caractérisée en ce que** le composant (14) est associé à une masse de soudure (22) assurant une connexion électrique avec ladite au moins une électrode (20).

10. Structure selon l'une dés revendications 1 ou 9, **caractérisée en ce que** ledit au moins un composant (14) est associé à au moins un élément de liaison filaire (20b) assurant une connexion électrique avec ladite au moins une électrode (20).

11. Structure selon l'une quelconque des revendications précédentes, **caractérisée en ce que** l'élément de couvercle (28) est en métal.

## Patentansprüche

1. Befestigungsanordnung, umfassend:
- ein im wesentlichen ebenes Substrat (10) mit einem Abschnitt (12), der eine Befestigungsstelle für mindestens eine optoelektronische Komponente (14) definiert,
- eine optoelektronische Komponente (14), die auf dem Substrat an der Befestigungsstelle (12) befestigt ist,
- mindestens eine Wellenleiterstruktur (16, 18) mit ebenem Lichtwellenleiterschaltkreis (PLC), die auf dem Substrat (10) ausgebildet ist, und sich bis zu der Befestigungsstelle (12) erstreckt, um eine für die Komponente (14) vorgesehene Durchleitungsstruktur für optische Signale zu definieren,
- mindestens eine Elektrode (20), die über der Wellenleiterstruktur (16, 18) für ebene Lichtwellenschaltkreise angeordnet ist, wobei sich die mindestens eine Elektrode (20) bis zu der Befestigungsstelle (12) erstreckt, um eine für die Komponente (14) vorgesehene Durchleitungsstruktur für elektrische Signale zu definieren,
- eine ringähnliche Struktur (26), die die Befestigungsstelle (12) durchgängig umschließt, wobei die ringähnliche Struktur (26) das ebene Substrat (12) hermetisch abschließt, und
- ein durchgehendes Abdeckelement (28), das angeordnet ist, um die Befestigungsstelle (12) zu überdecken, und das einen äußeren Randabschnitt (32) aufweist, der sich koextensiv zu der ringähnlichen Struktur (26) ausdehnt, und
- eine hermetische Dichtungsmasse (30), die sich durchgehend zwischen dem Randabschnitt (32) des Abdeckelementes (26) und der ringähnlichen Struktur (26) erstreckt, wodurch die Komponente (14) an der Befestigungsstelle (12) hermetisch abgedichtet ist.

2. Anordnung nach Anspruch 1, wobei das Substrat (10) eine Plattform ausgebildet aus Glas, Silizium oder Keramik umfaßt.

3. Anordnung nach einem der Ansprüche 1 oder 2, wobei das ebene Substrat (10) einen Profilabschnitt (12) aufweist, der die Befestigungsstelle (12) für die Komponente (14) definiert.

4. Anordnung nach einem der vorangehenden Ansprüche, wobei diese eine dielektrische Schicht (24) umfaßt, die das Substrat (10) zumindest am Rand überdeckt, und wobei die ringähnliche Struktur (26) über der dielektrischen Schicht vorgesehen ist.

5. Anordnung nach einem der vorangehenden Ansprüche, wobei die ringähnliche Struktur (26) ein Metallmaterial umfaßt.

6. Anordnung nach einem der vorangehenden Ansprüche, wobei das Abdeckelement (28) ein becherähnliches Element ist.

7. Anordnung nach Anspruch 1 oder 6, wobei das Abdeckelement (28) einen flachen Randflansch (32) aufweist, der den äußeren Randabschnitt definiert.

8. Anordnung nach einem der vorangehenden Ansprüche, wobei die hermetische Dichtungsmasse (30) eine Lötmasse zwischen dem äußeren Randabschnitt (32) des Abdeckelements (28) und der ringförmigen Struktur (26) ist.

9. Anordnung nach einem der vorangehenden Ansprüche, wobei die Komponente (14) eine zugeordnete Lötmasse (22) aufweist, die elektrischen Kontakt mit der mindestens einen Elektrode (20) vorsieht.

10. Anordnung nach Anspruch 1 oder 9, wobei die mindestens eine Komponente (14) mindestens ein zugeordnetes Drahtverbindungselement (20b) aufweist, welches eine elektrische Verbindung mit der mindestens einen Elektrode (20) vorsieht.

11. Anordnung nach einem der vorangehenden Ansprüche, wobei das Abdeckelement (28) aus einem Metallmaterial besteht.
